# EUROPEAN PATENT SPECIFICATION

(11) **EP 2 537 893 B1**
(45) Date of publication and mention of the grant of the patent: **13.07.2016**
(21) Application number: 11744530.4
(22) Date of filing: 04.02.2011
(51) Int. Cl.: C08L 23/08, C08K 3/26, C08L 71/00, C09K 3/10, H01L 31/042

(54) **SEALING FILM FOR PHOTOVOLTAIC MODULES AND PHOTOVOLTAIC MODULES USING SAME**
DICHTUNGSFILM FÜR PHOTOVOLTAIKMODULE UND PHOTOVOLTAIKMODULE DAMIT
FILM DE SCELLEMENT POUR MODULES PHOTOVOLTAÏQUES, ET MODULES PHOTOVOLTAÏQUES L'UTILISANT

(30) Priority: 18.02.2010 JP 2010033204
(43) Date of publication of application: 26.12.2012
(73) Proprietor: Bridgestone Corporation, Tokyo 104-8340 (JP)
(72) Inventor: INOUE Yoshihiko, Yokohama-shi Kanagawa 244-8510 (JP); KATAOKA Hisataka, Yokohama-shi Kanagawa 2448510 (JP)
(74) Representative: Oxley, Robin John George
(86) International application number: PCT/JP2011/052355
(87) International publication number: WO 2011/102242

(56) References cited:
- WO-A1-2011/007717
- WO-A1-2011/016233
- JP-A- 2005 029 588
- JP-A- 2008 053 377
- JP-A- 2008 053 377

## Description

### Technical Field

The present invention relates to a solar cell sealing film comprising chiefly ethylene-vinyl acetate copolymer, particularly a solar cell sealing film which prevents an occurrence of acetic acid in a heat and humidity environment, and maintains an insulation property.

### Background Art

In recent year, a solar cell (solar cell module) has been widely employed as a device directly converting solar energy into electric energy from the viewpoints of effective use of natural resources and prevention of environmental pollution. Further developments of solar cells are in progress with the object of power generation efficiency and residence to climate.

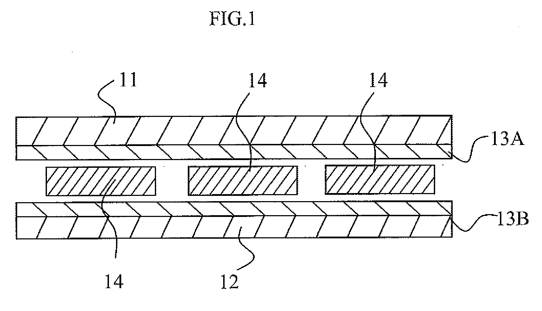

As shown in Fig. 1, a solar cell generally includes a transparent front side protection material 11 (e.g., glass plate), a front side sealing film 13A, photovoltaic elements 14 (e.g., photovoltaic elements made of silicon), a backside sealing film 13B and a backside protection material 12 (backside covering member). For preparing a solar cell, first, the foregoing members are successively laminated in this order. Then, the laminated body is subjected to vacuum degassing, subsequently, heating under pressure for adhesively combining the laminated body by crosslinking or curing a front side sealing film 13A and a backside sealing film 13B.

In order to generate a large electrical output, a solar cell has plural photovoltaic elements 14 connected to each other. Therefore, sealing films 13A, 13B having high insulation properties seal the photovoltaic elements for ensuring electrical insulation properties between the photovoltaic elements 14.

Furthermore, developments of thin-film solar cells, such as thin-film silicon type solar cell, an amorphous silicon film type solar cell and copper indium selenide (CIS) type solar cell are also developed. These thin-film solar cells are prepared by, for example, forming a thin-film photovoltaic element such as a semiconductor layer on surface of a transparent material such as a glass substrate and a polyimide substrate by chemical vapor deposition method, etc., superposing a sealing film, etc. on the thin-film photovoltaic element and adhesively combining with the laminated body.

As a sealing film for the solar cells, a film made of ethylene-polar monomer copolymer such as ethylene-vinyl acetate copolymer (occasionally abbreviated to EVA) or ethylene-ethylacrylate copolymer (EEA) is used. Especially, the ethylene-vinyl acetate copolymer is preferably used because it has low cost and high transparency. Furthermore, in an EVA film used for a sealing film, the combination of crosslinkers such as organic peroxides with the EVA improves crosslink density for improvements of strength and durability of the film.

It is often the case that a solar cell is used outdoors in a circumstance of a high temperature and high humidity which is exposed to wind and rain for a long time. In this regard, when EVA film is used as a sealing film, an occurrence of acetic acid can be generated by hydrolysis of EVA over time under the influence of moisture/water penetration to the solar cell. The acetic acid may have contact with a conductor or an electrode in photovoltaic elements to cause rust generation/corrosion and a resulting decrease of power generation efficiency.

Patent document 1 discloses an EVA film as a transparent film used as a sealing film for a solar cell. The EVA film comprises an acid acceptor having a mean particle diameter of 5µm or less in amount of 0.5 wt.% or less. The Use of the EVA film as a sealing film for a solar cell can prevent the occurrence of acetic acid from EVA, and improve the durability of the solar cell.

### Patent Document

### Prior Art Documents

Patent Document 1: JP (TOKKAI) 2005-029588 A

Reference is also made to JP 2008-53377, which dislcoses a solar cell sealing film according to the preamble of claim 1.

### Summary of the Invention

### Problem to be solved by the Invention

However, although the addition of hydrotalcite, for example, as the acid acceptor to an EVA film for a solar cell sealing film enables to prevent the occurrence of acetic acid in a heat and humidity environment, the addition occasionally causes a decrease of an insulation property which is important property of a sealing film. The decrease of an insulation property causes a leakage of electrical current, to bring about a decrease of power generation efficiency of the solar cell.

It is therefore an object of the present invention to provide a solar cell sealing film comprising chiefly ethylene-vinyl acetate copolymer, which prevents the acid in a heat and humidity environment, additionally maintains an insulation property.

Furthermore, an object of the present invention is to provide a solar cell using the sealing film.

### Means for Solving Problem

The above object is attained by a solar cell sealing film, comprising, ethylene-vinyl acetate copolymer, a crosslinker and hydrotalcite,
which further contains a (meth)acrylate compound represented by the following formula (I):

[Formula 1] 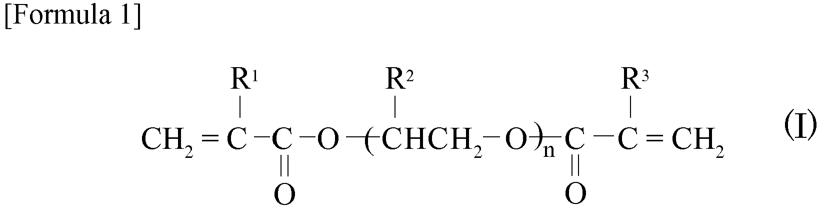 in which R¹, R² and R³ each independently represent H or CH₃, and n is an integer of 9 to 14, wherein the crosslinker is organic peroxide and a content of the hydrotalcite is 0.5 to 1.5 parts by weight based on 100 parts by weight of the ethylene-vinyl acetate copolymer. The addition of hydrotalcite to the solar cell sealing film comprising chiefly ethylene-vinyl acetate copolymer makes it possible to prevent the occurrence of acetic acid in a heat and humidity environment. Furthermore, the addition of the (meth)acrylate compound of the formula (I) together with a crosslinker makes it possible to suppress the decrease of an electrical insulation property caused by the addition of hydrotalcite. The cause of the function is considered to be that the compound having ethyleneoxy groups or propyleneoxy groups is firmly incorporated in the crosslinked structure of EVA, whereby an ion can be trapped.

Preferred embodiments of the solar cell sealing film according to the present invention are described as follows:
(1) R² of the formula (I) represents H.
(2) A content of the (meth)acrylate compound is 0.1 to 1.0 part by weight based on 100 parts by weight of the ethylene-vinyl acetate copolymer.

Furthermore, the above object is attained by a solar cell obtained by use of the solar cell sealing film of the present invention.

### Advantageous Effects of the Invention

According to the present invention, the solar cell sealing film comprising chiefly ethylene-vinyl acetate copolymer comprises hydrotalcite, whereby the occurrence of acetic acid in a heat and humidity environment can be prevent. Furthermore, the addition of the (meth)acrylate compound of the formula (I) together with a crosslinker makes it possible to suppress the decrease of an electrical insulation property caused by the addition of hydrotalcite. Hence, the solar cell sealing film of the present invention has a superior insulation property without adversely affecting photovoltaic elements in a heat and humidity environment.

Therefore, the use of the solar cell sealing film of present invention makes it possible to provide a solar cell which has improved durability in a heat and humidity environment, and enhanced power generation efficiency.

### Brief Description of the Drawings

[Fig. 1] Fig. 1 is an illustrative drawing of a solar cell.

### Description of Embodiments

A solar cell sealing film of the present invention comprises an ethylene-vinyl acetate copolymer, a crosslinker, and hydrotalcite, and further contains a (meth)acrylate compound represented by the following formula (I): 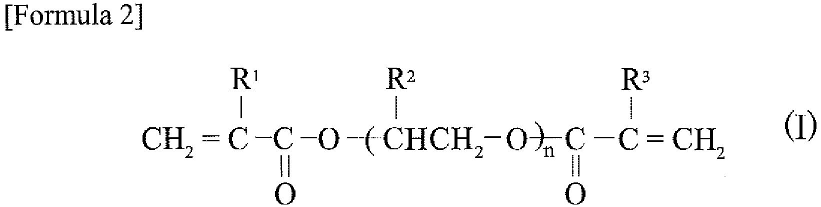 in which R¹, R² and R³ each independently represent H or CH₃, and n is an integer of 9 to 14. In the invention, the (meth)acrylate means acrylate or methacrylate. The addition of hydrotalcite to the solar cell sealing film makes it possible to prevent the occurrence of acetic acid from EVA in a heat and humidity environment. Furthermore, the addition of the (meth)acrylate compound of the formula (I) (also referred as to the compound I) makes it possible to suppress the decrease of an electrical insulation property caused by the addition of hydrotalcite. The cause of the function is not apparent. However, the following mechanism is considered.

In more detail, the compound I has a given number of ethyleneoxy groups or propyleneoxy groups, and two carbon-carbon double bonds (-C=C-) devided from (meth)acryloyl groups. Hence the compound I in the sealing film is firmly incorporated into the crosslinked structure of ethylene-polar monomer copolymer. It is considered that the decrease of an electrical insulation property caused by the addition of hydrotalcite occurs due to ion movement caused by hydrotalcite particles having electric charges. However, in case the compound I is present in the sealing film, the hydrotalcite particles can be trapped by the ethyleneoxy groups or propyleneoxy groups of the compound I. The compound I is firmly incorporated in the crosslinked structure, whereby the ion movement in the sealing film can be restricted and the decrease of an electrical insulation property can be suppressed.

The solar cell sealing film of the invention is explained in detail below.

### [(meth)acrylate compound of the formula (I)]

The compound I of the invention has 9 to 14 ethyleneoxy groups (-CH₂CH₂- wherein R² is H), or 9 to 14 propyleneoxy groups (-CH(CH₃)CH₂- wherein R² is CH₃), and further (meth)acrylate groups or (meth)acryloyloxy groups at the both ends of the molecule, as shown the formula I. In the invention, the (meth)acryloyl means acryloyl or methacryloyl, and the (meth)acryloyloxy means acryloyloxy or methacryloyloxy.

As mentioned above, it is considered that the function that the ethyleneoxy groups or propyleneoxy groups are ionically-bonded to the hydrotalcite particles suppresses the decrease of an electrical insulation property. The ethyleneoxy group (where in R² is H) is preferred because it has reduced steric hindrance and hence is capable of easily trapping the hydrotalcite particles. In the case the "n" that is number of alkyleneoxy group is less than 9, the compound I does not have sufficient capacity trapping the hydrotalcite particles and therefore cannot suppress the decrease of an electrical insulation property. In contrast, in the case the "n" is more than 14, the compound I shows decrease of compatibility with EVA to bring about lowering of processing properties. Moreover, the compound I is incorporated in the crosslinked structure due to two carbon-carbon double bonds (-C=C-) of (meth)acryloyl groups at its both sides, and the EVA is crosslinked by the crosslinker to form the crosslinked structure. In contrast, a compound having one (meth)acryloyl group only at one side is not sufficiently incorporated in the crosslinked structure, which cannot fully suppress the ion movement of the hydrotalcite particles not to bring about a sufficient decrease of an electrical insulation property.

Examples of the compound I include polyethylene glycol di(meth)acrylate having 9 to 14 ethyleneoxy groups such as nonaethylene glycol di(meth)acrylate, decaethylene glycol di(meth)acrylate, undecaethylene glycol di(meth)acrylate, dodecaethylene glycol di(meth)acrylate, tridecaethylene glycol di(meth)acrylate and tetradecaethylene glycol di(meth)acrylate; and polypropylene glycol di(meth)acrylate having 9 to 14 propyleneoxy groups such as nonapropylene glycol di(meth)acrylate, decapropylene glycol di(meth)acrylate, undecapropylene glycol di(meth)acrylate, dodecapropylene glycol di(meth)acrylate, tridecapropylene glycol di(meth)acrylate and tetradecapropylene glycol di(meth)acrylate. These compounds can be employed singly or in combination of two or more kinds.

Of these compounds, polyethylene glycol di(meth)acrylate having 9 to 14 ethyleneoxy groups is preferred. The compounds are more preferably nonaethylene glycol di(meth)acrylate and tetradecaethylene glycol di(meth)acrylate. Particularly preferred is tetradecaethylene glycol di(meth)acrylate.

The solar cell sealing film of the present invention contains the (meth)acrylate compound preferably in amount of 0.1 to 1.0 part by weight, more preferably 0.1 to 0.5 part by weight, based on 100 parts of the EVA. The use of the compound I in too small amount does not occasionally bring about the sufficient decrease of an electrical insulation property, whereas the use of the compound I in excessive amount does not occasionally bring about the inhibition of function of the crosslinker to reduce the crosslinked density and the reduction of the processing properties such as difficulty in kneading.

### [Ethylene-vinyl acetate copolymer]

The content of vinyl acetate recurring unit of the ethylene-vinyl acetate copolymer (EVA) of the invention is preferably in the range of 20 to 35% by weight, more preferably in the range of 20 to 30% by weight, particularly preferably in the range of 24 to 28% by weight, based on weight of EVA. The less content of vinyl acetate, the harder EVA composition is obtained. When the vinyl acetate content is less than 20% by weight, the sealing film crosslinked or cured at high temperature is apt not to show sufficiently high transparency. On the other hand, when the content is more than 35% by weight, the sealing film is apt to have insufficient hardness, furthermore to form carboxylic acid, alcohol or amine to generate bubbles at the interface between the sealing film and the protective material.

The solar cell sealing film of the invention may collaterally contain other ethylene-polar monomer copolymer including ethylene-unsaturated carboxylic acid copolymers such as ethylene-acrylic acid copolymer and ethylene-methacrylic acid copolymer; ionomers of ethylene-unsaturated carboxylic acid copolymers in which a part or all of the carboxyl groups are neutralized with a metal; ethylene-unsaturated carboxylic ester copolymers such as ethylene-methyl acrylate copolymer, ethylene-ethyl acrylate copolymer, ethylene-methyl methacrylate copolymer, ethylene-isobutyl acrylate copolymer and ethylene-n-butyl acrylate copolymer; ethylene-unsaturated carboxylic ester-unsaturated carboxylic acid copolymers such as ethylene-isobutyl acrylate-methacrylic acid copolymer and ethylene-n-butyl acrylate-methacrylic acid copolymer; ionomers of ethylene-unsaturated carboxylic ester-unsaturated carboxylic acid copolymer in which a part or all of the carboxyl groups are neutralized with a metal; and ethylene-vinyl ester copolymers, polyvinyl acetal resin (e.g., polyvinyl formal, polyvinyl butyral (PVB resin), modified PVB) or vinyl chloride resin, in addition to EVA.

### [Hydrotalcite]

Any hydrotalcite compounds and similar compounds thereof can be employed as the hydrotalcite of the invention. The hydrotalcite can be naturally produced or synthesized from a variety of metal salts. The hydrotalcite has a layered structure and is capable of intercalating anion between the layers. The hydrotalcite is generally a salt of divalent and trivalent metal hydroxide, for example represented by the following formula (II):
[Formula 3]

M²⁺_{xM}³⁺_{y}(OH)_{2x+2y}A_{y/n} •zH₂O (II)

in which M²⁺ represents divalent metal, M³⁺ represents trivalent metal, A represents anion, n represents valence of the anion (A), and z represents hydration number.

Examples of M²⁺ include Mg²⁺, Fe²⁺, Zn²⁺, Ca²⁺, Li²⁺, Ni²⁺, Co²⁺ and Cu²⁺. M²⁺ preferably represents Mg²⁺. Examples of M³⁺ include Al³⁺, Fe³⁺ and Mn³⁺. M³⁺ preferably represents Al³⁺. n is preferably in the range of 1 to 3. Examples of A include CO₃²⁻, OH⁻, F⁻, Cl⁻, Br⁻, NO₃⁻, HPO₃²⁻ and SO₄²⁻. A preferably represents CO₃²⁻. Examples of specific hydrotalcite include Mg_{4.5}Al₂(OH)₁₃CO₃ • 3.5H₂O, Mg₄Al₂(OH)₁₂CO₃ • 3H₂O, Mg₅Al₂(OH)₁₄CO₃ •4H₂O, Mg₆Al₂(OH)₁₆CO₃ • 4H₂O, Mg₈Al₂(OH)₂₀CO₃ • 5H₂O, Mg₁₀Al₂(OH)₂₂(CO₃)₂ • 4H₂O, Mg₆Al₂(OH)₁₆HPO₄ • 4H₂O, Ca₆Al₂(OH)₁₆CO₃ • 4H₂O and Zn₆Al₆(OH)₁₆CO₃ • 4H₂O. Particularly, a salt of hydroxide of Mg²⁺ and Al³⁺ is preferably as the hydrotalcite in the present invention for preventing the occurrence of acetic acid.

If the hydrotalcite is contained in excessive amount, the resultant sealing film is apt to reduce in transparency. As to the transparency of the solar cell sealing film, for example, Haze value (according to JIS K 7136 (2000)) is preferably 10% or less. Therefore, the hydrotalcite is contained in amount of 0.5 to 1.5 parts by weight, more preferably 0.5 to 1.0 part by weight, based on 100 parts by weight of the ethylene-vinyl acetate copolymer.

### [Crosslinker]

The crosslinker of the invention enable the formation of the crosslinked structure of ethylene-vinyl acetate copolymer. An organic peroxide or photopolymerization initiator is used as the crosslinker.

The organic peroxide is used because the resultant sealing film is improved in temperature dependencies in adhesion, transparency, humidity resistance and penetration resistance.

Any organic peroxides that can be decomposed at a temperature of not less than 100°C to generate radical(s) can be employed as the above-mentioned organic peroxide. The organic peroxide is generally selected in the consideration of film-forming temperature, conditions for preparing the composition, curing (bonding) temperature, heat resistance of body to be bonded, storage stability. In particular, it is preferable to use a material having a decomposition temperature of not less than 70°C in a half-life of 10 hours.

From the viewpoint of resin processing temperature and storage stability, examples of the organic peroxides include benzoyl peroxide-type cure agents, tert-hexyl peroxypivalate, tert-butyl peroxypivalate, 3,5,5-trimethylhexanoyl peroxide, di-n-octanoyl peroxide, lauroyl peroxide, stearoyl peroxide, 1,1,3,3-tetramethylbutylperoxy-2-ethyl hexanoate, succinic acid peroxide, 2,5-dimethyl-2,5-di(tert-butylperoxy)hexane, 2,5-dimethyl-2, 5-di(2-ethylhexanoylp eroxy)hexane,
1-cyclohexyl-1-methylethylperoxy-2-ethylhexanoate, tert-hexylperoxy-2-ethylhexanoate, 4-methylbenzoyl peroxide, tert-butylperoxy-2-ethyl hexanoate, m-toluoyl+benzoylperoxide, benzoyl peroxide, 1,1 -bis(tert-butylperoxy)-2-methylcyclohexane, 1.1-bis(tert-hexylperoxy)-3,3,5-trimethylcyclohexane,
1,1-bis(tert-hexylperoxy)cyclohexane,
1,1-bis(tert-butylperoxy)-3,3,5-trimethylcyclohexane,
1,1-bis(tert-butylperoxy)cyclohexane,
2,2-bis(4,4-di-tert-butylperoxycyclohexyl)propane, 1,1-bis(tert-butylperoxy)cyclododecane, tert-hexylperoxyisopropyl monocarbonate, tert-butylperoxy maleic acid, tert-butylperoxy-3,3,5-trimethyl hexanoate, tert-butyl peroxylaurate, 2,5-dimethyl-2,5-di(methylbenzoylperoxy)hexane, tert-butylperoxyisopropyl monocarbonate, tert-butylperoxy-2-ethylhexyl monocarbonate, tert-hexyl peroxybenzoate, and 2,5-dimethyl-2,5-di(benzoylperoxy)hexane.

As the benzoyl peroxide-type cure agents, any organic peroxides that can be decomposed at a temperature of not less than 70°C to generate radical(s) can be employed. It is preferable to use a material having a decomposition temperature of not less than 50°C in a half-life of 10 hours. The benzoyl peroxide-type cure agents are selected in the consideration of conditions for preparing the composition, film-forming temperature, curing (bonding) temperature, heat resistance of body to be bonded, storage stability. Examples of the benzoyl peroxide-type cure agents include benzoyl peroxide, 2,5-dimethylhexyl-2,5-bisperoxy benzoate, p-chlorobenzoyl peroxide, m-toluoyl peroxide, 2,4-dicyclobenzoyl peroxide, tert-butylperoxy benzoate. The benzoyl peroxide-type cure agents can be employed singly or in combination of two or more kinds.

As the organic peroxide, it is particularly preferred are 2,5-dimethyl-2,5-di(tert-butylperoxy)hexane and 1.1-bis(tert-hexylperoxy)-3,3,5-trimethylcyclohexane, which bring about a solar cell sealing film having a superior insulation property.

The content of the organic peroxide in the sealing film is preferably in the range of 0.1 to 2.0 parts by weight, more preferably in the range of 0.2 to 1.5 parts by weight based on 100 parts by weight of an ethylene-vinyl acetate copolymer. When the content of the crosslinker is less, the insulation property of the sealing film is apt to be decreased. When the content of the crosslinker is excessive, the compatibility of the crosslinker with the copolymer is apt to be decreased.

Any known photopolymerization initiators can be employed as the crosslinker. Preferred are initiators having high storage stability after addition thereof. Examples of the photopolymerization initiators include acetophenone type initiators such as 2-hydroxy-2-methyl-1-phenylpropane-1-on,
1-hydroxycyclohexylphenylketone, and 2-methyl-1-[4-(methylthio)phenyl]-2-morphorino-propane-1-on; benzoin type initiators such as benzoylmethylketal; benzophenone type initiators such as benzophenone, 4-phenylbenzophenone and hydroxybenzophenone; and thioxanthone type initiators such as isopropylthioxanthone and 2,4-diethylthioxanthone. Further, as special type, there can be mentioned methylphenylglyoxylate. Especially preferred are 2-hydroxy-2-methyl-1-phenylpropane-1-on,
1-hydroxycyclohexylphenylketone, 2-methyl-1-[4-(methylthio)phenyl]-2-morphorino-propane-1-on and benzophenone. These photopolymerization initiators can be employed, if necessary, together with one or more kinds of a photopolymerization promoter such as a benzoic acid type compound (e.g., 4-dimethylaminobenzoic acid) or a tertiary amine compound by mixing the initiator with the promoter in optional ratio. The initiator can be singly or in combination of two or more kinds.

The photopolymerization initiator is preferably contained in the range of 0.5 to 5.0 parts by weight based on 100 parts by weight of ethylene-vinyl acetate copolymer.

### [Crosslinking auxiliary agent]

The solar cell sealing film of the present invention may contain crosslinking auxiliary agent if necessary. The crosslinking auxiliary agent enables increase of gel fraction of ethylene-vinyl acetate copolymer and improvement of adhesive property and durability of the sealing film.

The crosslinking auxiliary agent is generally used in an amount of 10 parts by weight or less, preferably in the range of 0.1 to 5.0 parts by weight, more preferably in the range of 0.1 to 2.5 parts by weight based on 100 parts by weight of ethylene-vinyl acetate copolymer. Accordingly, a sealing film having an excellent adhesive property can be obtained.

Examples of the crosslinking auxiliary agents (compounds having radical polymerizable groups as functional group) include tri-functional cross-linking auxiliary agents such as triallyl cyanurate and triallyl isocyanurate, and mono- or bi-functional crosslinking auxiliary agents of (meth)acryl esters (e.g., NK Ester, etc.). Among these compounds, triallyl cyanurate and triallyl isocyanurate are preferred, especially triallyl isocyanurate.

### [Adhesion improver]

The solar cell sealing film of the invention preferably has excellent adhesion from the viewpoint of sealing performance with in a solar cell. Therefore the sealing film preferably contains an adhesion improver. As the adhesion improver, silane-coupling agents can be employed whereby an EVA film having excellent adhesion strength can be obtained. Examples of the silane-coupling agents include γ-chloropropyltrimethoxysilane, vinyltriethoxysilane, vinyltris(β-methoxyethoxy)silane, γ-methacryloxypropyltrimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, vinyltrichlorosilane, γ-mercaptopropyltrimethoxysilane, γ-aminopropyltriethoxysilane and N-β-(aminoethyl)-γ-aminopropyltrimethoxysilane. The silane-coupling agents can be used singly, or in combination of two or more kinds. Especially, γ-methacryloxypropyltrimethoxysilane is preferred.

The content of the silane coupling agent is preferably in the range of 0.1 to 0.7 parts by weight, particularly in the range of 0.15 to 0.65 parts by weight based on 100 parts by weight of ethylene-vinyl acetate copolymer.

### [Others]

The sealing film of the invention can further contain, if necessary, various additives such as plasticizers, acryloxy group-containing compounds and/or methacryloxy group-containing compounds other than the compound I of the invention, and/or epoxy group-containing compounds, for improvement or adjustment of various properties of the resultant film (e.g., mechanical strength, optical characteristics such as transparency, heat-resistance, light-resistance, or crosslinking rate, etc.).

Generally, polybasic acid esters and polyhydric alcohol esters can be used as the plasticizer, although there are not particular restrictions to plasticizer to be used. Examples of the plasticizers include dioctyl phthalate, dihexyl adipate, triethylene glycol-di-2-ethylbutyrate, butyl sebacate, tetraethylene glycol diheptanoate and triethylene glycol dipelargonate. The plasticizers can be used singly, or in combination of two or more kinds. The plasticizer is preferably contained in amount of not more than 5 parts by weight based on 100 parts by weight of ethylene-vinyl acetate copolymer.

Generally, derivatives of acrylic acid or methacrylic acid such as esters and amides of acrylic acid or methacrylic acid can be used as the acryloxy group-containing compound and methacryloxy group-containing compound. Examples of the ester residue include linear alkyl groups (e.g., methyl, ethyl, dodecyl, stearyl and lauryl), cyclohexyl group, tetrahydrofurfuryl group, aminoethyl group, 2-hydroxyethyl group, 3-hydroxypropyl group, 3-chloro-2-hydroxypropyl group. Example of the amide includes diacetone acryl amide. Further, examples of the esters include esters of acrylic acid or methacrylic acid with polyhydric alcohol such as ethylene glycol, triethylene glycol, polypropylene glycol, polyethylene glycol, trimethylol propane or pentaerythritol.

Examples of the epoxy group-containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol(ethyleneoxy)₅glycidyl ether, p-tert-butylphenyl glycidyl ether, diglycidyl adipate, diglycidyl phthalate, glycidyl methacrylate and butyl glycidyl ether.

The content of the acryloxy group-containing compounds, the methacryloxy group-containing compounds or the epoxy group-containing compounds is preferably in the range of 0.5 to 5.0 parts by weight, particularly in the range of 1.0 to 4.0 parts by weight based on 100 parts by weight of ethylene-vinyl acetate copolymer.

Furthermore, the sealing film may further contain ultraviolet absorbent, light stabilizer and antioxidant. The use of ultraviolet absorbent suppresses deterioration of ethylene-vinyl acetate copolymer by irradiation of light whereby a solar cell sealing film suffers from yellowing. Examples of the ultraviolet absorbent, though are not particularly restricted, preferably include benzophenone-type ultraviolet absorbents such as 2-hydroxy-4-methoxybenzophenone,
2-hydroxy-4-n-dodecyloxybenzophenone, 2,4-dihydroxybenzophenone, 2,2'-dihydroxy-4-methoxybenzophenone and 2-hydroxy-4-n-octoxybenzophenone. The content of the benzophenone-type ultraviolet absorbent is preferably in the range of 0.01 to 5 parts by weight based on 100 parts by weight of ethylene-vinyl acetate copolymer.

The use of the light stabilizer also suppresses deterioration of ethylene-vinyl acetate copolymer by irradiation of light whereby a solar cell sealing film suffers from yellowing. A so-called hindered amine light stabilizer can be preferably used as the light stabilizer. Examples of the light stabilizer include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD and CHIMASSORB 944LD (each manufactured by Ciba Specialty Chemicals Co., Ltd.), and UV-3034 (manufactured by B. F. Goodrich). The light stabilizers can be each used singly, or in combination of two or more kinds. The content of the light stabilizer is preferably in the range of 0.01 to 5 parts by weight based on 100 parts by weight of ethylene-vinyl acetate copolymer.

Examples of the antioxidants include hindered phenol-type antioxidants such as N,N'-hexan-1,6-diyl-bis[3-(3,5-di-tert-butyl-4-hydroxyphenyl) propionamide], phosphorus-type heat stabilizers, lactone-type heat stabilizers, vitamin E-type heat stabilizers and sulfur-type heat stabilizers.

The solar cell sealing film of the invention can be prepared in accordance with heretofore known processes.

For example, the sealing film can be prepared by molding a composition including the above-discussed materials into a sheet-shaped product by extrusion molding or calendar molding (calendaring). Otherwise, the composition is dissolved in a solvent, the thus obtained solution is applied to an appropriate support by an appropriate coater, and then the applied solution is dried to form a coated film. Thus, a sheet-shaped product can be prepared. Additionally, the heating temperature at the film-formation is preferably a temperature that the crosslinker cause no reaction or little reactions. For instance, the temperature is preferably in the range of 40 to 90°C, particularly in the range of 50 to 90°C. The thickness of the solar cell sealing film, though is not particularly restricted, preferably is in the range of 50µm to 2mm.

### [Solar cell]

The structure of the solar cell of the invention is not particularly restricted, as long as the solar cell sealing film of the invention is used. Examples of the structure include a structure that photovoltaic elements are sealed through the solar cell sealing films between a transparent front side protection material and a backside protection material. In the invention, "front side" corresponds to a side of the photovoltaic element irradiated with the light (light-receiving side), whereas "backside" corresponds to the reverse side of the light-receiving side of the photovoltaic elements.

For sufficiently sealing the photovoltaic elements in the solar cell, for instance, a transparent front side protection material 11, a front side sealing film 13A, photovoltaic elements 14, a backside sealing film 13B and a backside protection material 12 can be laminated in this order, as shown in Fig. 1. Thereafter, the sealing film can be crosslinked or cured according to a conventional process such as the application of heating and pressure.

For example, the laminated body can be bonded under the application of heating and pressure by using a vacuum laminator in the conditions of temperature of 135 to 180°C, preferably 140 to 180°C, especially 155 to 180°C, degassing time period of 0.1 to 5min, pressing pressure of 0.1 to 1.5kg/cm² and pressing time period of 0.1 to 5min. This heating and pressure enables the crosslinking of the ethylene-vinyl acetate copolymer contained in the front side sealing film 13A and the backside sealing film 13B, whereby the transparent front side protection material 11, the backside protection material 12 and the photovoltaic elements 14 are combined through the front side sealing film 13A and the backside sealing film 13B, which results in seal of the photovoltaic elements 14.

In addition, the solar cell sealing film of the invention can be used for not only a solar cell using single-crystalline or polycrystalline silicone crystal type photovoltaic elements as shown in Fig. 1, but also thin-film solar cells, such as thin-film silicon type solar cell, an amorphous silicon film type solar cell and copper indium selenide (CIS) type solar cell. Examples of a structure of thin-film solar cell include;
a structure that on a thin-film photovoltaic element formed on surface of a transparent front side protection material such as a glass substrate, a polyimide substrate and a fluorine resin type transparent substrate by chemical vapor deposition method, etc., the solar cell sealing film of the invention and a backside protection material are superposed and adhesively combined,
a structure that on a thin-film photovoltaic element formed on a surface of a backside protection material, the solar cell sealing film of the invention and a transparent front side protection material are superposed and adhesively combined, and
a structure that a transparent front side protection material, a front side solar cell sealing film, a thin-film photovoltaic element, a backside solar cell sealing film and a backside protection material are laminated in this order, and adhesively combined.

The solar cell sealing film of the invention prevents the occurrence of acetic acid in a heat and humidity environment, and has a superior insulation property, therefore, makes it possible to provide a solar cell having improved durability and enhanced power generation efficiency.

The transparent front side protection material 11 used in the solar cell of the invention is preferably a glass substrate such as silicate glass. The thickness of the glass substrate is generally in the range of 0.1 to 10mm, preferably 0.3 to 5mm. The glass substrate can be chemically or thermally tempered.

The backside protection material 12 for use in the invention is preferably a plastic film such as polyethylene terephthalate (PET). From the viewpoint of heat resistance and moisture resistance, a fluorinated polyethylene film or especially a film having structure of fluorinated polyethylene film/Al/ fluorinated polyethylene film laminated in this order is preferred.

The solar cell (including thin-film solar cell) of the invention is characterized by the specific sealing films used as the front side and/or the backside sealing film. Therefore, there is no particular restriction on the materials of the solar cell except for the sealing films (i.e., transparent front side protection material, backside protection material, photovoltaic elements, etc.). Those materials can have the same structures/compositions as those in heretofore known solar cells.

### Examples

The invention is illustrated in detail using the following Examples.

### [Examples 1 to 12, Comparative Examples 1 to 14]

Materials of the formulation set forth in Table 1 and Table 2 were fed to a roll mill, and kneaded at 70°C to prepare a composition for a solar cell sealing film. The composition for a solar cell sealing film was formed by calendaring processing at temperature of 70°C and cooled to prepare a solar cell sealing film (thickness: 0.6mm).

### [Evaluation methods]

### (1) Calendering property

In the preparation of the solar cell sealing film, calendering property is evaluated as follows.
o: Calendering can be conducted without problems such as trouble in kneading.
X : Calendering can be difficultly conducted.

### (2) Generation amount of acetic acid

A glass plate (FL glass: thickness; 3mm), each of the resultant solar cell sealing film and a polyvinyl fluoride film (thickness; 50µm) were laminated in this order. The laminate was temporarily bonded under application of pressure by using a vacuum laminator at 90°C, and then heated to be crosslinked to gel fraction of 90%. The resultant laminate was used as module for measurement of generation amount of acetic acid.

Then the module was allowed to stand in the environment of temperature of 121°C and humidity of 100%RH for 240 hours.

Subsequently the solar cell sealing film was taken out of the module. 1.0g of the sealing film was immersed in acetone (2.0ml) at room temperature (25°C) for 48 hours, and the amount (ppm) of acetic acid contained in the acetone extract was determined by gas chromatography. Based on the amount of acetic acid generated from the sealing film (Comparative Example 14) containing no hydrotalcite and no (meth)acrylate compound, a sample having a generation amount of acetic acid of less than 3500ppm was regarded as acceptance, and a sample having that of not less than 3500ppm was non-acceptance.

### (3) Volume resistivity

The resultant solar cell sealing film was cut to prepare a sample having a size of 100mm×100mm, which was temporarily bonded under application of pressure by using a vacuum laminator at 90°C, and then heated to be crosslinked to gel fraction of 90%.

Volume resistivity (LogΩ• cm) of each of the resultant samples was measured by using a high resistivity meter (Hiresta UP available from Mitsubishi Chemical Corporation) in an atmosphere of 60°C. Based on the value of volume resistivity of the sealing film (Comparative Example 14) containing no hydrotalcite and no (meth)acrylate compound, a sample having a value of volume resistivity of not less than13.0 was regarded as acceptance, and a sample having that of less than 13.0 was non-acceptance.

### (4) HAZE value

A glass plate (thickness; 3mm), each of the resultant solar cell sealing film and a glass plate (thickness; 3mm) were laminated in this order. The laminate was crosslinked in the same manner as mentioned in item (2). HAZE value (%) of the laminate was measured according to JIS-K-7136 (2000) by using HAZE meter (NDH-2000, manufactured by NIPPON DENSHOKU INDUSTRIES Co.,Ltd.).

### (5) Decision criteria

○: All the items (1) to (3) were evaluated as the acceptance.
Δ: Only the evaluation of item (1) was ×, and other items were evaluated as the acceptance.
×: Samples not to satisfy the above-mentioned evaluation.

In addition, item (4) was used as an indicator for designing preferred compositions.

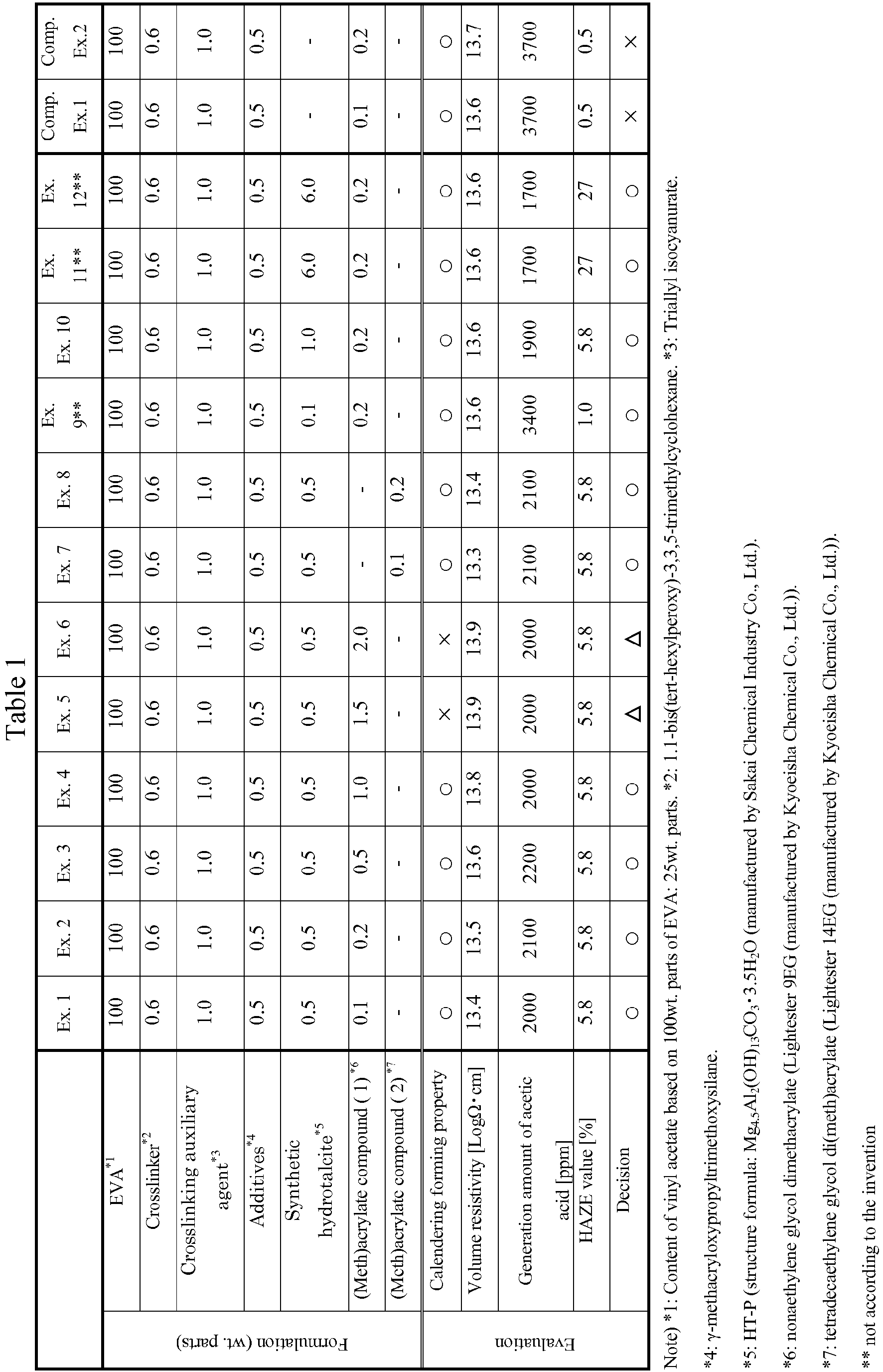

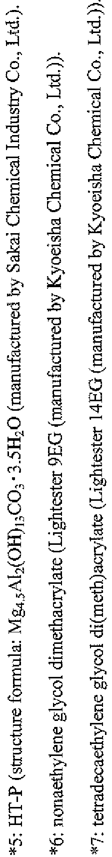

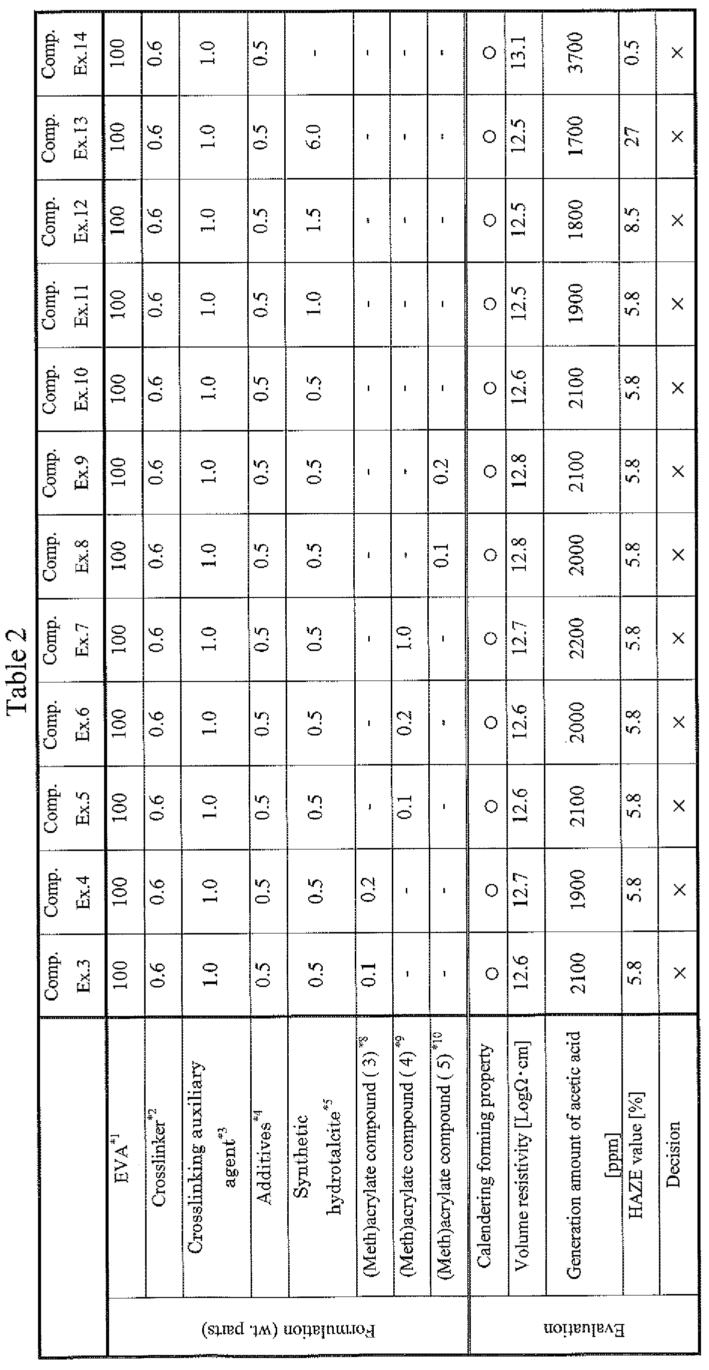

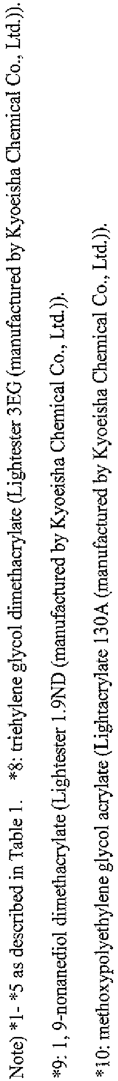

### [Evaluation result]

Volume resistivity of each of the resultant samples is showed in Table 1 and Table 2. Solar cell sealing films containing 0.1 to 6.0 parts by weight of hydrotalcite and 0.1 to 2.0 parts by weight of (meth)acrylate compounds represented by the formula (I) wherein R¹ and R³ are CH₃, R² is H, and n is 9 or 14 (compound I), which are described in Examples 1-12, are evaluated. As a result, the films of all Examples 1-12 are regarded as acceptance regarding the evaluations of volume resistivity and the generation amount of acetic acid. However, the solar cell sealing films containing that the compound I in amount of 1.5 parts by weight and 2.0 parts by weight (Examples 5 and 6) show calendering property bad. Thus the content of the compound I is more preferably in the range of 0.1 to 1.0 part by weight based on 100 parts by weight of EVA. Furthermore, the film containing hydrotalcite in amount of 6.0 parts by weight (Example 12) shows HAZE value of more than 10% and reduced transparency. Thus the content of the hydrotalcite is more preferably in the range of 0.1 to 1.5 parts by weight based on 100 parts by weight of EVA.

In contrast, the films containing no hydrotalcite (Comparative Examples 1 and 2), and the film containing no hydrotalcite and no (meth)acrylate compound (Comparative Example 14) are not regarded as acceptance regarding the evaluation of the generation amount of acetic acid. Furthermore, the films containing no (meth)acrylate compound (Comparative Examples 10 to 13) show extremely reduced volume resistivity. As to the volume resistivity, the differences between Comparative Example 10 and Examples 1 and 2 are larger than that between Comparative Example 14 and Comparative Examples 1 and 2, and hence it is perceived that the sealing film containing hydrotalcite is remarkably improved in volume resistivity.

Even if a (meth)acrylate compound is contained in a sealing flm, the films containing (meth)acrylate compound wherein n (number of ethyleneoxy group) is 3 (Comparative Examples 3 and 4), the films containing (meth)acrylate compound having no ethyleneoxy group (Comparative Examples 5 to 7), and the films containing (meth)acrylate compound having acryloyl group only one end (Comparative Examples 8 and 9) are not regarded as acceptance regarding the evaluations of the volume resistivity, and hence do not show the effect of suppressing the decrease of an electrical insulation property.

The above-mentioned results reveal that the use of the hydrotalcite and the (meth)acrylate compound of the formula(I) prevents the occurrence of acetic acid in a heat and humidity environment, and suppresses the decrease of an electric insulation property.

The present invention is not restricted to the constitution of the Embodiments and the Examples as mentioned above and therefore can be varied widely within the gist of the invention.

### Industrial Applicability

The present invention makes it possible to provide a solar cell which has improved durability in a heat and humidity environment, and enhanced power generation efficiency.

### Description of the reference numbers

- 11:: Transparent front side protection material
- 12:: Backside protection material
- 13A:: Front side sealing film
- 13B:: Backside sealing film
- 14:: Photovoltaic elements

## Claims

1. A solar cell sealing film, comprising, ethylene-vinyl acetate copolymer, a crosslinker and hydrotalcite,
which further contains a (meth)acrylate compound represented by the following formula (I): 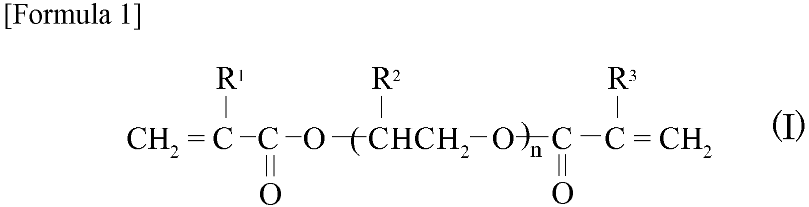 in which R¹, R² and R³ each independently represent H or CH₃, and n is an integer of 9 to 14,
wherein the crosslinker is organic peroxide;
**characterized in that** a content of the hydrotalcite is 0.5 to 1.5 parts by weight based on 100 parts by weight of the ethylene-vinyl acetate copolymer.

2. The solar cell sealing film as defined in claim 1, wherein R² of the formula (I) represents H.

3. The solar cell sealing film as defined in claim 1 or 2, wherein a content of the (meth)acrylate compound is 0.1 to 1.0 part by weight based on 100 parts by weight of the ethylene-vinyl acetate copolymer.

4. A solar cell obtained by use of a solar cell sealing film as defined in any of claims 1 to 3.

## Patentansprüche

1. Solarzellenversiegelungsfolie umfassend Ethylen-Vinylacetat-Copolymer, ein Vernetzungsmittel und Hydrotalcit,
die ferner eine (Meth)acrylatverbindung enthält, die durch die folgende Formel (I) dargestellt ist: 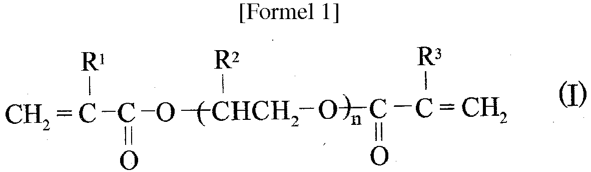 wobei R¹, R⁷ und R³ jeweils unabhängig H oder CH₃ darstellen und n eine ganze Zahl von 9 bis 14 ist,
wobei das Vernetzungsmittel ein organisches Peroxid ist;
**dadurch gekennzeichnet, dass** ein Gehalt des Hydrotalcits 0,5 bis 1,5 Gewichtsteile, auf 100 Gewichtsteile des Ethylen-Vinylacetat-Copolymers bezogen, beträgt.

2. Solarzellenversiegelungsfolie wie in Anspruch 1 definiert, wobei R² der Formel (I) H darstellt.

3. Solarzellenversiegelungsfolie wie in Anspruch 1 oder 2 definiert, wobei ein Gehalt der (Meth)acrylatverbindung 0,1 bis 1,0 Gewichtsteile, auf 100 Gewichtsteile des Ethylen-Vinylacetat-Copolymers bezogen, beträgt.

4. Solarzelle, die durch Verwendung einer Solarzellenversiegelungsfolie wie in einem der Ansprüche 1 bis 3 definiert, erhalten wird.

## Revendications

1. Film de scellement pour cellule solaire, comprenant un copolymère éthylène-acétate de vinyle, un agent de réticulation et une hydrotalcite,
qui contient en outre un composé de (méth)acrylate représenté par la formule (I) suivante: 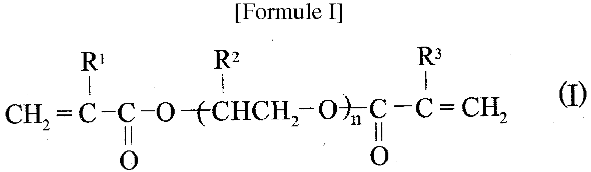 dans laquelle R¹, R⁷ et R³ représentent chacun indépendamment H ou CH₃, et n est un entier de 9 à 14,
dans lequel l'agent de réticulation est un peroxyde organique;
**caractérisé en ce qu'**une teneur en l'hydrotalcite est de 0,5 à 1,5 partie en poids sur la base de 100 parties en poids du copolymère éthylène-acétate de vinyle.

2. Film de scellement pour cellule solaire tel que défini dans la revendication 1, dans lequel R² de la formule (I) représente H.

3. Film de scellement pour cellule solaire tel que défini dans la revendication 1 ou 2, dans lequel une teneur en le composé de (méth)acrylate est de 0,1 à 1,0 partie en poids sur la base de 100 parties en poids du copolymère éthylène-acétate de vinyle.

4. Cellule solaire obtenue en utilisant un film de scellement pour cellule solaire tel que défini dans l'une quelconque des revendications 1 à 3.
